# EUROPEAN PATENT APPLICATION

(11) **EP 4 814 457 A1**
(43) Date of publication of application: **30.09.2026**
(21) Application number: 25305438.1
(22) Date of filing: 26.03.2025
(51) Int. Cl.: G01K 7/01

(54) **METHOD AND CIRCUIT ADAPTED TO MONITOR THE JUNCTION TEMPERATURE OF A POWER SEMICONDUCTOR**

(71) Applicant: Mitsubishi Electric R&D Centre Europe B.V., 1119 NS Schiphol Rijk Amsterdam (NL); MITSUBISHI ELECTRIC CORPORATION, Chiyoda-ku Tokyo 100-8310 (JP)
(72) Inventor: Quemener, Vincent, 35708 RENNES CEDEX 7 (FR); DEGRENNE, Nicolas, 35708 RENNES CEDEX 7 (FR)
(74) Representative: Plasseraud IP

(57) **Abstract**

Device for sensing a junction temperature of a power semiconductor (1) controlled by a PWM generator (3), comprising a pull-down resistor (10) between a gate and an emitter of said power semiconductor (1), a sense switch (11) connected between said emitter and a ground connection, a command circuit (12) for turning ON and OFF of said sense switch, said command circuit (12) being triggered by said PWM generator (3), a measurement means (13) configured to monitor a voltage response V_{E} between said emitter and ground during OFF periods of said sense switch and conversion means to calculate an internal gate resistance R_{gin} of the power semiconductor representative of said junction temperature based on said voltage response V_{E}.

## Description

### Technical Field

This disclosure pertains to the field of the monitoring of the junction temperature of power semiconductors and their protection against excessive temperature situations.

### Background Art

In the field of power semiconductors, access to the junction temperature of a power semi-conductor device such as IGBT or MOSFET during its operation is essential to increase the lifetime of a power module made with such a power semi-conductor. For instance, this allows to monitor the state of the health of the power module and to protect the power module in case of unusual temperature and over-temperature detection.

A first prior art method uses a chip-embedded sense diode in the power semi-conductor die, such sense diode having a reproducible, linear, and high negative sensitivity of its threshold voltage with temperature. A relatively simple external circuit is used to detect an under-value of such threshold voltage or to measure such threshold voltage during operation of the power semi-conductor. However, the implementation of the diode on the chip results in a loss of active area of the power semi-conductor and increases the number of connections.

A second method in prior art uses the internal gate resistance of the power semi-conductor as a temperature sensitive electric parameter (TSEP). This method is based on the injection of a dc current through the gate of the power semi-conductor during a PWM operation of such semi-conductor. The variation of the gate resistance Rgᵢₙ with the temperature can be measured with the voltage response to the injection of current.

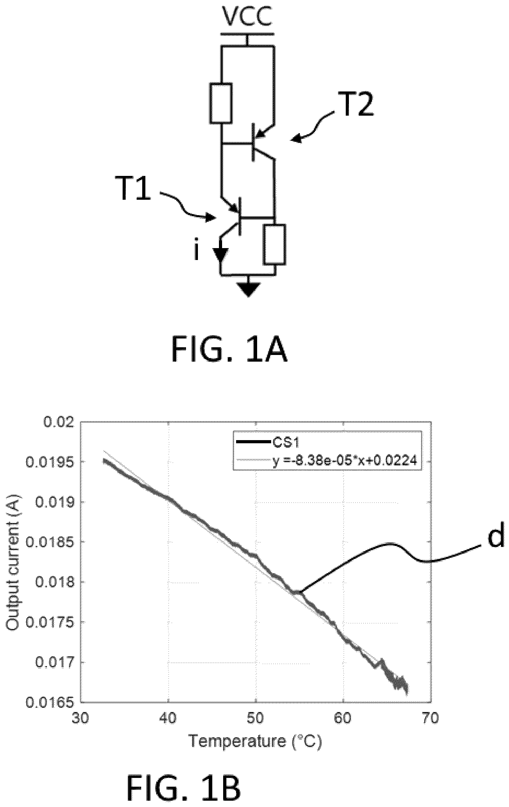

This method requires a precise and stable current source which must remain constant during the measurement. The complexity and cost of such a circuit can be a limitation to use in some industrial application. Several circuits are proposed in the prior art, based on bipolar junction transistors (BJT). An example of circuit providing a current is shown in figure 1. Such a circuit with two transistors T1, T2 has the advantages of being simple and relatively cheap. However, stability of the current source remains low which results in a reduction of the accuracy of the estimation of the junction temperature Tj. Moreover, affordable current source circuits are also very sensitive to the temperature variation. This is shown in the figure 1B, where the current drift d with the temperature of the circuit of figure 1 is about 84µA/°C in accordance with the approximated curve y = 8.38*e*^{-0.5} · *x* + 0.0224 where y is the output current of the current source and x the temperature in °C. An example of power semiconductor health monitoring through periodic gate current injection is described in European Patent application EP 24305034.1 filed January 8th, 2024, in name of the Applicants.

As a result, the methods based on the internal gate resistance are precise and accurate, but their main limitation is related to complexity and the cost of implementation of a stable and low-drift current source. A new method which simplifies the circuit and reduces the cost must be found to adopt this internal gate resistance temperature measurement technic.

### Summary

In view of such problems, the present disclosure aims to provide an alternative circuit by removing the regular current source and replacing it with a pull-down resistor in order to estimate the junction temperature in an accurate and low-cost manner.

The present disclosure concerns a method and circuit adapted to monitor the junction temperature of a power semiconductor by using the internal gate resistance of the power semiconductor as a temperature sensitive parameter. More precisely, the present disclosure concerns a device for sensing a junction temperature of a power semiconductor controlled by a PWM generator which comprises a pull-down resistor between a gate and an emitter of said power semiconductor, a sense switch connected between said emitter and a ground connection, a command circuit for turning ON and OFF of said sense switch, said command circuit being triggered by said PWM generator, a measurement means configured to monitor a voltage response VE between said emitter and ground during OFF periods of said sense switch and conversion means to calculate an internal gate resistance R_{gin} of the power semiconductor representative of said junction temperature based on said voltage response VE.

Use of a resistor between the gate and emitter of the power semiconductor has the advantages to reduce electrical noise, the complexity and the cost of the Tj estimation method by replacing the typical current source by a simple pull-down resistor to estimate the junction temperature of the power semiconductor.

The pull-down resistor discharges an internal gate capacitor of the power semiconductor during turn-off periods of the sense switch thus generating a voltage signal promotional to the value of the internal gate resistance of the transistor.

The power semiconductor is preferably an IGBT or a MOSFET.

Turn off periods of the switch may be provided during ON or OFF states of the power semiconductor subject to the PWM operation.

Preferably, the sense switch is turned OFF for a duration between 100 ns and 1000 ns within a PWM ON state or OFF state of the power semiconductor to provide a measurement window for the measurement means.

The device may further comprise a validation switch driven to turn ON or OFF the connection of the pull-down resistor with the base and emitter of the power semiconductor in opposition with the sense switch to allow connection of the pull-down resistor between said gate and emitter during OFF periods of the sense switch.

The device may comprise a first pull-down resistor with a first validation switch driven by a controller to allow connection of the first pull-down resistor between said gate and emitter during OFF periods of the sense switch and a positive gate driver voltage period.

The device may may comprise a second pull-down resistor with a second validation switch driven by said controller to allow connection of the second pull-down resistor between said gate and emitter during OFF periods of the sense switch and a positive gate driver voltage period.

In a realization mode, the device may comprise a serial RC circuit in parallel with said sense resistor.

A value of the resistor R and a value C of the capacitor of the serial RC circuit may be chosen according to the following relation R·C= C_{g}·R_{gin}±10%, Cg being the internal gate/emitter capacitance of the power semiconductor and R_{gin} being the internal gate/emitter resistance of the power semiconductor.

The present disclosures also concerns a method comprising turning OFF the sense switch during specified periods for discharging the internal gate capacitor of the power semiconductor through said pull-down resistor and measuring the resulting voltage signal V_{E} between the emitter connection of said semiconductor and ground with a measurement means during part of said turning OFF of the sense switch and calculating a temperature of said semiconductor voltage signal proportional to the value of the internal gate resistance of the transistor calculated based on said voltage signal V_{E}.

Turn OFF periods of the switch may be provided during ON or OFF states of the power semiconductor subject to the PWM operation.

An acquisition of an emitter voltage V_{E} may be performed at a timing within 20 ns to 100 ns of the turn OFF of the sense switch to reduce the effect of the gate capacitance on measurement of R_{gin}.

A validation switch being positioned in series with the pull-down resistor, the method may comprise switching the validation switch in opposition with the sense switch to make measures when the validation switch is ON and the sense switch is OFF.

The circuit comprising two pull-down resistors and two validation switch each positioned in series with one of said pull-down resistors, the method may comprise switching ON a first validation switch during positive PWM alternances and OFF periods of the sense switch and switching OFF a second validation switch during negative PWM alternances and OFF periods of the sense switch.

A serial RC circuit being positioned in parallel with the pull-down resistor the method may comprise switching the validation switch in opposition with the sense switch to make measures when the validation switch is ON and the sense switch is OFF and measuring a peak emitter voltage V_{E} value upon switching OFF the sense switch.

### Brief Description of Drawings

Other features, details and advantages will be shown in the following detailed description and on the figures, on which:
Figures 1A, 1B show an example of current source and its behavior with temperature;
Figure 2 is a schematic view of a first embodiment of a temperature sensing device;
Figure 3 is a view of temperature detection events on a PWM curve for the embodiment of figure 2;
Figure 4 is a curve showing the emitter voltage versus time during temperature sensing for the embodiment of figure 2;
Figure 5 is schematic view of a second embodiment of a temperature sensing device;
Figure 6 is schematic view of a third embodiment of a temperature sensing device;
Figure 7 is a view of temperature detection events on a PWM curve for the embodiment of figure 6;
Figure 8 is schematic view of a fourth embodiment of a temperature sensing device;
Figure 9 shows the voltage signal with S3 OFF and S4 ON in figure 8.

### Description of Embodiments

In figure 1A as discussed above a simple current source used for generating a gate-emitter current in a power semiconductor such as an IGBT or MOSFET has a current drift shown in figure 1B.

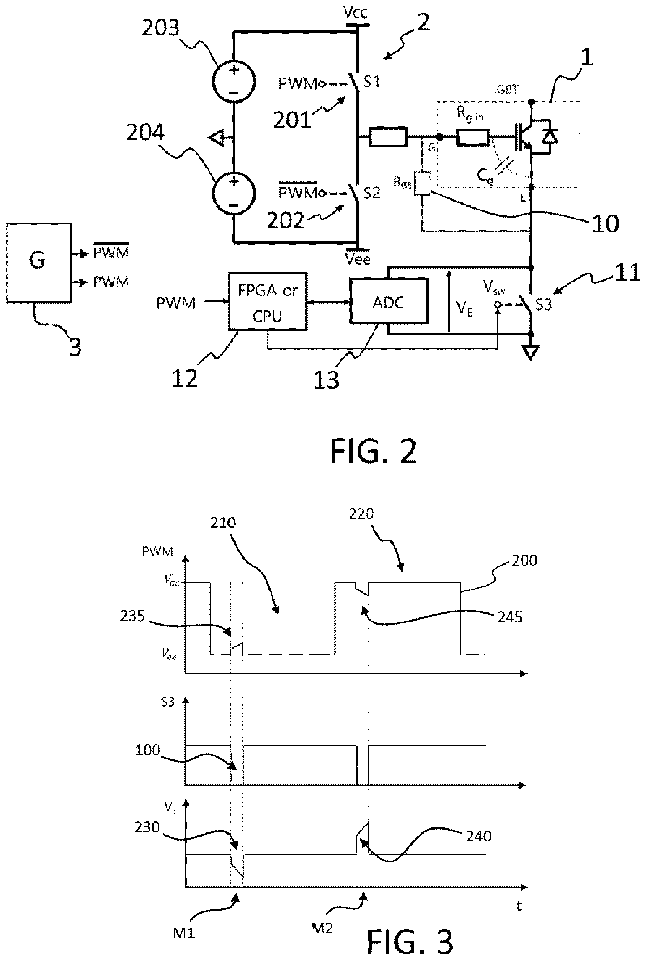

In order to avoid temperature measurement errors during operation of the power semiconductor, the present disclosure in the embodiment of figure 2 bases the temperature measurement of a power semiconductor 1 such as an IGBT, controlled by a PWM generator 3, on a circuit comprising a pull-down resistor R_{GE} 10 for sensing the internal gate resistance R_{gin} of such semiconductor.

The circuit of figure 2 comprises the pull-down resistor 10 between the gate and the emitter of the power semiconductor 1, a sense switch 11 connected between said emitter and a ground connection, a command circuit 12 for turning ON and OFF the sense switch during measurement periods M1, M2 on figure 3, said command circuit 12 being triggered by said PWM generator 3 to trigger the OFF periods 100 of the sense switch 11 within Vₑₑ 210 state or V_{cc} 220 state, an ADC 13 configured to monitor a voltage response V_{E} between said emitter and ground during OFF periods of said sense switch and conversion means to calculate an internal gate resistance R_{gin} of the power semiconductor representative of said junction temperature based on said voltage response V_{E}.

The pull-down resistor R_{GE} 10 is chosen to have a value for example in the range of 1kΩ to 10 kΩ in order to discharge the gate capacitance when S3 is OFF for a short duration and to allow recording the potential change of the emitter voltage V_{E}.

The switching of the sense switch S3 11 can be synchronized using the PWM signal from the PWM generator 3 and can be measured either during the ON state and the OFF state of the IGBT 1, as shown in the chart of figure 3.

In such a circuit, V_{E} can be described by the following equation depending on the state of the IGBT:
${V}_{E} = \left({R}_{gint}\left({T}_{j}\right)+\frac{t}{{C}_{g}}\right) \times \frac{{V}_{cc}}{{R}_{GE}} or {V}_{E} = \left({R}_{gint}\left({T}_{j}\right)+\frac{t}{{C}_{g}}\right) \times \frac{{V}_{ee}}{{R}_{GE}}$

Where V_{cc} and Vₑₑ correspond of the voltage of the gate in the ON state 220 of the IGBT and OFF state 210 of the IGBT, respectively.

This figure 3 shows the diagram with Tⱼ measurement during ON-state and OFF-state of the IGBT. The Tⱼ measurement is performed when S3 is turned OFF 100 for a duration typically comprised between 100ns to 1000ns.

During ON-state of the IGBT, the gate voltage 200 is held at the potential V_{cc} 220 (for example at 20V). During the Tj measurement 100, the gate capacitance C_{g} is slightly discharging in the resistor R_{GE}, which results in a reduction of the gate potential 245 and a positive V_{E} voltage signal 240.

During OFF-state of the IGBT, the gate voltage is held at the potential Vₑₑ (for example at -5V), the discharge of the gate capacitance C_{g} results in an increase of the gate voltage and a negative V_{E} voltage signal 230. Moreover, for the same value of R_{GE}, both V_{E} signals during ON state and OFF state will not have the same absolute amplitude value which allows to differentiate such states at the ADC 13 level.

The sense switch 11 turning OFF for a duration which can be set between 100 ns and 2000 ns within a PWM ON state or OFF state of the power semiconductor provides a measurement window for the ADC 13.

The discharge of C_{g} in R_{GE} fixed by the duration of S3 in OFF state generates a small voltage response V_{E} depending on the internal gate resistance R_{gin} in series with the gate capacitance C_{g} according to the equation (1):

The internal gate resistor depends linearly on the temperature and can be described by the equation (2):
${R}_{gin} \left({T}_{j}\right) = \left({δR}_{gint}⋅{T}_{j}+1\right) {R}_{g 0}$

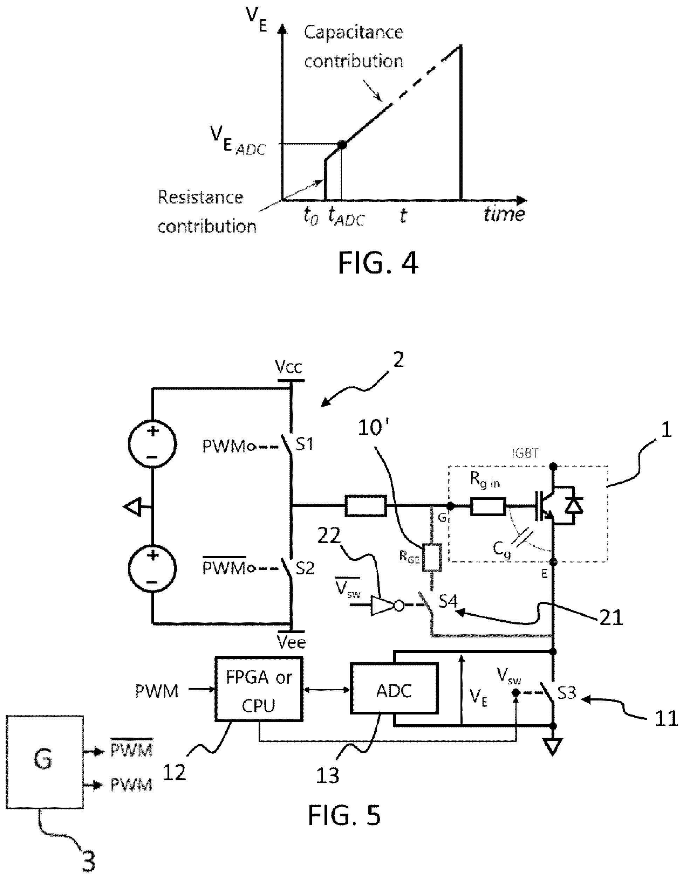

The capacitance part in V_{E} is proportional of time as shown in figure 4. Thus, the acquisition with the ADC with one point should be done at a timing close to the turn-OFF of S3. This will limit the contribution of the gate capacitance and the signal will depend mainly on the value of R_{gin}, as described by equation (3):
${lim}_{t \to 0} {V}_{E} = {R}_{gint} \left({T}_{j}\right) \times {I}_{inj}$

In the Figure 4 where the V_{E} signal is a function of time duration, the ADC acquisition timing t_{ADC} in the range of 100-200ns from the turn-off of S3 at t₀. The main contribution of the signal is the in such case the gate resistor with a small contribution of the capacitance.

An advantage is that the variation of the capacitance with the operation contribution will have a limited impact on the temperature estimation. Moreover, the short acquisition timing will limit the perturbation on the gate voltage provided by the gate driver and the current decay during the discharge of the capacitance remains small for an acquisition timing close to the turn-off of the switch S3.

As said above, the pull-down resistance 10 used to discharge the gate capacitor must have a value in the range of 1kΩ - 10kΩ to not affect the gate driver operation and limit the losses. However, this value of resistance can limit the dynamic of the signal to observe the variation of the internal gate resistance with the temperature which remains very low around 0.1%/°C.

The embodiment of figure 5 shows an example of implementation to resolve this issue by using a lower resistance in series with a switch S4 21 controlled by the reverse of the command of the sense switch S3 21. Such a validation switch S4 22 driven to turn ON or OFF the connection of the pull-down resistor 10' with the base and emitter of the power semiconductor 1 in opposition with the sense switch 11 to allow connection of the pull-down resistor between said gate and emitter during OFF periods of the sense switch 11 allows to use a resistance R_{GE} 10 with value in the range of hundreds of ohms, e.g. 100 Ω to 900 Ω to increase the sensitivity of the measurement without disturbing the gate voltage during operation times where S4 22 is OFF and S3 is ON.

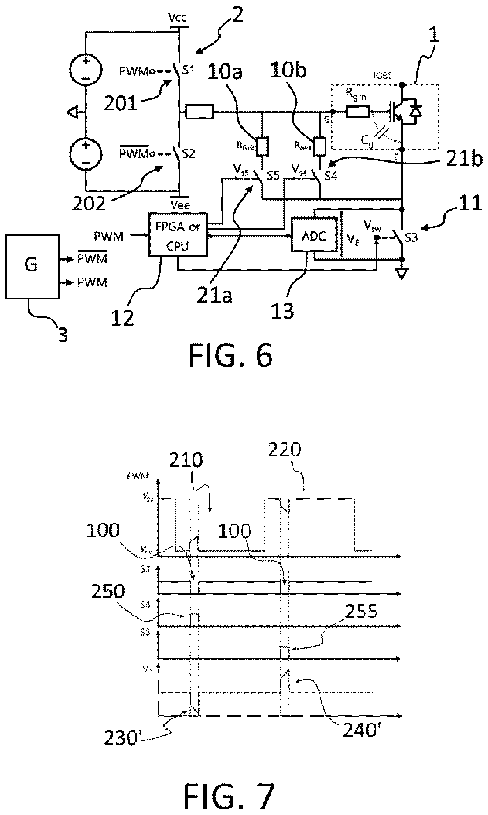

In the third embodiment according to figure 6:

A first pull-down resistor 10a with a first validation switch 21a is driven by the controller 12 to allow connection of the first pull-down resistor 10a between said gate and emitter during OFF periods of the sense switch 11 and a positive gate driver voltage period.

A second pull-down resistor 10b with a second validation switch 21b driven by said controller 12 allows the connection of a second pull-down resistor 10b between said gate and emitter during OFF periods of the sense switch 11 and a positive gate driver voltage period.

In the first embodiment of figure 2, the V_{E} signal absolute value is dependent on the value of the gate driver rail voltages, V_{cc} and Vₑₑ. Thus, the signal in OFF state and ON state of the IGBT are different by using one single pull-down resistance. In the embodiment of figure 6 connecting a network of different resistance in series with switches to tune the discharge of the gate capacitor as a function of the value of V_{cc} and Vₑₑ. In the third embodiment, the FPGA can control the value of the resistance chosen 21a or 21b according to the PWM state. In that way the absolute amplitude of the V_{E} signal obtained in ON-state and OFF-state can be tuned individually.

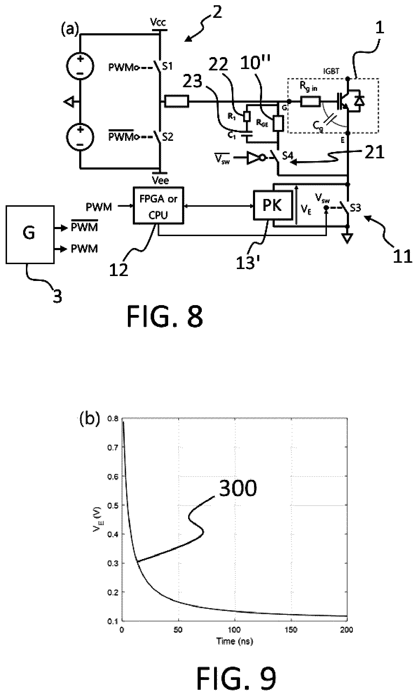

In the fourth embodiment of figure 8 a serial RC circuit with resistor 22 and capacitor 23 is provided in parallel with the sense resistor R_{GE} 10".

The circuit behaves like a capacitive voltage divider and the signal V_{E} can be described by the following equation (4) when the gate driver is in ON-state:
${V}_{e} = {V}_{cc} \times \frac{{R}_{gin} \left({T}_{j}\right) + \frac{t}{{C}_{g}}}{\left({R}_{gin}\left({T}_{j}\right)+\frac{t}{{C}_{g}}\right) + \left({R}_{1}+\frac{t}{{C}_{1}}\right)}$

The signal V_{E} 300 versus time is shown in figure 9 with a peak shape for time close to the turn-OFF of the sense switch S3 11 and the turn-ON of validation switch S4 21. For time close to zero, we only observe the contribution of the resistive voltage divider and decreases for longer timing when the capacitive part prevails. The circuit behaves as a capacitive voltage divider.

The value of R₁ 22 is from 1 to 100 times the value of R_{gin} and the value of C₁ is 0.01 to 0.1 times the gate resistance C_{g} of the IGBT. Such values can be chosen as a function to the R_{gin} and C_{g} in order to get a peak dependent of the temperature. R_{GE} is used to discharge C₁ between two sequences of Tj measurement. Thus, R_{GE} in the range of 10kΩ-100 kΩ can be high in order to limit the gate driver losses.

Advantageously, the measurement means for the V_{E} signal peak can be a peak detector PK 13' rather than an ADC.

In one mode of implementation, C₁, R₁, R_{gin} and C_{g} are such that:
${C}_{1} ⋅ {R}_{1} \approx {C}_{g} ⋅ {R}_{gin}$

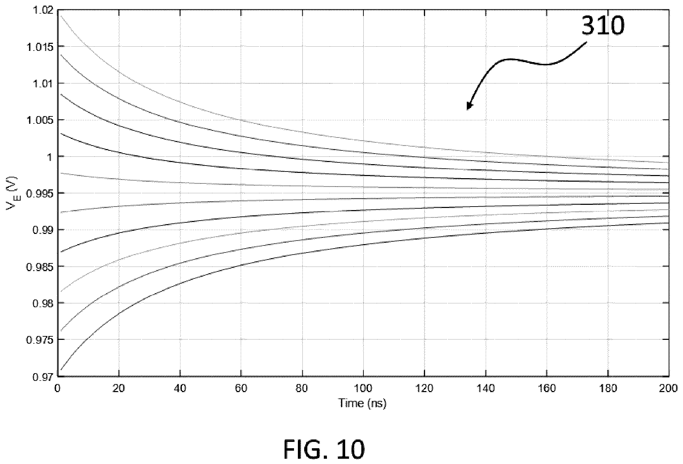

Thus, the voltage V_{E} has an almost square shape instead of a peak shape, and the sampling or peak detection or integration is facilitated. An example of the signal for different R_{gin} from 1.95 to 2.05 using the equation 5: C₁ = 0.1nF, C_{g} = 20nF and R₁ = 400Ω) is shown in figure 10. In such a configuration an integrator can be implemented to measure the V_{E} area. This allows the measurement to become time independent. A possible approximated calculation of values is R·C= C_{g}·R_{gin}±10%.

The present disclosures concerns further a method for sensing a junction temperature of a power semiconductor controlled by a PWM generator 3 with a pull down resistor between a gate and an emitter of a power semiconductor to be monitored, said method comprising turning OFF a sense switch 11 between an emitter of the power semiconductor to be monitored and ground during specified periods for discharging the internal gate capacitor of the power semiconductor through said pull-down resistor and measuring the resulting voltage signal V_{E} between the emitter connection of said semiconductor and ground with a measurement means 13 during part of said turning OFF of the sense switch 11 and calculating a temperature of said semiconductor voltage signal proportional to the value of the internal gate resistance of the transistor calculated based on said voltage signal V_{E}.

Turn OFF periods of the sense switch may be provided during ON or OFF states of the power semiconductor subject to the PWM operation.

To minimize influence of the internal capacitance of the power semiconductor, an acquisition of an emitter voltage V_{E} may be performed at a timing close to the turn OFF of the sense switch, in particular within 20 ns to 100 ns of such turn OFF event.

In case a validation switch is positioned in series with the pull-down resistor 10 between the power semiconductor base and emitter, the method comprises switching the validation switch 21 in opposition with the sense switch 11 to make measures when the validation switch 21 is ON and the sense switch 11 is OFF. When the validation switch is OFF this allows the pull-down resistor to be disconnected from the semiconductor gate - emitter path in order not to provide perturbations or current losses during operation of the power semiconductor.

In case the circuit comprises two pull-down resistors 10a, 10b and two validation switch 21a, 21b each positioned in series with one of said pull-down resistors 10a, 10b as in figure 6, the method comprises switching ON 255 a first validation switch 21a during positive PWM alternances 220 and OFF periods 100 of the sense switch 11 and switching OFF 250 a second validation switch 21b during negative PWM alternances 210 and OFF periods 100 of the sense switch 11.

With the circuit of figure 8 where a serial RC circuit 22, 23 is positioned in parallel with the pull-down resistor 10 the method comprises switching the validation switch 21 in opposition with the sense switch to make measures when the validation switch is ON and the sense switch is OFF and measuring a peak emitter voltage VE value upon switching OFF the sense switch 11. Such method avoids the use of an ADC.

The invention defined by the appended claims is not limited to the embodiments described herein and, in particular, the measurement means may also comprise a comparator to detect V_{E} voltages above a specified limit to prevent overheating of the power semiconductor which may also be a power MOSFET instead of an IGBT.

## Claims

1. - Device for sensing a junction temperature of a power semiconductor (1) controlled by a PWM generator (3), **characterized in that** it comprises a pull-down resistor (10) between a gate and an emitter of said power semiconductor (1), a sense switch (11) connected between said emitter and a ground connection, a command circuit (12) for turning ON and OFF of said sense switch, said command circuit (12) being triggered by said PWM generator (3), a measurement means (13) configured to monitor a voltage response V_{E} between said emitter and ground during OFF periods of said sense switch and conversion means to calculate an internal gate resistance R_{gin} of the power semiconductor representative of said junction temperature based on said voltage response V_{E}.

2. - Device for sensing a junction temperature of a power semiconductor according to claim 1, wherein the power semiconductor (1) is an IGBT or a MOSFET.

3. - Device for sensing a junction temperature of a power semiconductor according to claim 1 or 2, wherein the sense switch (11) is turned OFF for a duration between 100 ns and 1000 ns within a PWM ON state or OFF state of the power semiconductor to provide a measurement window for the measurement means (13).

4. - Device for sensing a junction temperature of a power semiconductor according to claim 1, 2 or 3, comprising further a validation switch (22) driven to turn ON or OFF the connection of the pull-down resistor (10') with the base and emitter of the power semiconductor (1) in opposition with the sense switch (11) to allow connection of the pull-down resistor between said gate and emitter during OFF periods of the sense switch (11).

5. - Device for sensing a junction temperature of a power semiconductor according to claim 4, comprising a first pull-down resistor (10a) with a first validation switch (21a) driven by a controller (12) to allow connection of the first pull-down resistor (10a) between said gate and emitter during OFF periods of the sense switch (11) and a positive gate driver voltage period; and comprises a second pull-down resistor (10b) with a second validation switch (21b) driven by said controller (12) to allow connection of the second pull-down resistor between said gate and emitter during OFF periods of the sense switch (11) and a positive gate driver voltage period.

6. - Device for sensing a junction temperature of a power semiconductor according to claim 4, comprising a serial RC circuit (22, 23) in parallel with said sense resistor (10).

7. - Device for sensing a junction temperature of a power semiconductor according to claim 6 wherein a value of the resistor R and a value C of the capacitor of the serial RC circuit are chosen according to the following relation R·C= C_{g}·R_{gin}±10%, Cg being the internal gate/emitter capacitance of the power semiconductor and R_{gin} being the internal gate/emitter resistance of the power semiconductor.

8. - Method for sensing a junction temperature of a power semiconductor controlled by a PWM generator (3) with a device according to any one of claims 1 to 7, said method comprising turning OFF the sense switch during specified periods for discharging the internal gate capacitor of the power semiconductor through said pull-down resistor and measuring the resulting voltage signal V_{E} between the emitter connection of said semiconductor and ground with a measurement means during part of said turning OFF of the sense switch (11) and calculating a temperature of said semiconductor voltage signal proportional to the value of the internal gate resistance of the transistor calculated based on said voltage signal V_{E}.

9. - Method according to claim 8, wherein turn OFF periods of the switch are provided during ON or OFF states of the power semiconductor subject to the PWM operation.

10. - Method according to claim 8 or 9, wherein an acquisition of an emitter voltage V_{E} is performed at a timing within 20 ns to 100 ns of the turn OFF of the sense switch (11) to reduce the effect of the gate capacitance on measurement of the R_{gin}.

11. - Method according to claim 8, 9 or 10, wherein a validation switch being positioned in series with the pull-down resistor (10) the method comprises switching the validation switch in opposition with the sense switch to make measures when the validation switch is ON and the sense switch is OFF.

12. - Method according to claim 11, wherein the circuit comprising two pull-down resistors (10a, 10b) and two validation switch (21a, 21b) each positioned in series with one of said pull-down resistors (10a, 10b), the method comprises switching ON (255) a first validation switch (21a) during positive PWM alternances (220) and OFF periods (100) of the sense switch (11) and switching OFF (250) a second validation switch (21b) during negative PWM alternances (210) and OFF periods (100) of the sense switch (11).

13. - Method according to claim 11, wherein a serial RC circuit (22, 23) being positioned in parallel with the pull-down resistor (10), the method comprises switching the validation switch in opposition with the sense switch to make measures when the validation switch is ON and the sense switch is OFF and measuring a peak emitter voltage V_{E} value upon switching OFF the sense switch (11).
